# EUROPEAN PATENT APPLICATION

(11) **EP 0 856 948 A1**
(43) Date of publication of application: **05.08.1998**
(21) Application number: 97309231.5
(22) Date of filing: 17.11.1997
(51) Int. Cl.: H03M 9/00

(54) **Serial-to-parallel converter**

(30) Priority: 31.01.1997 JP 19069/97
(71) Applicant: Oki Electric Industry Co., Ltd., Tokyo (JP)
(72) Inventor: Umezawa, Yoshiaki, 7-12, Toranomon 1-chome, Minato-ku Tokyo (JP)
(74) Representative: Read, Matthew Charles

(57) **Abstract**

The serial-to-parallel converter includes a plurality of store circuits which operates a parallel data converter being transferred serial data one by one in response to a plurality of parallel clock signals being shifted a phase at every cycle.

Accordingly, the serial-to-parallel converter can decrease an occurrence of an operation noise and improve reliability of a circuit operation.

## Description

### BACKGROUND OF THE INVENTION

### Field of the invention:

The present invention generally relates to semiconductor integrated circuits, and more particularly, the present invention relates to the serial-to-parallel converter which convert received serial data into corresponding parallel data.

This application is a counterpart application of Japanese application Serial Number 19069/1997, filed January 31, 1997, the subject matter of which is incorporated herein by reference.

### Description of the Related Art:

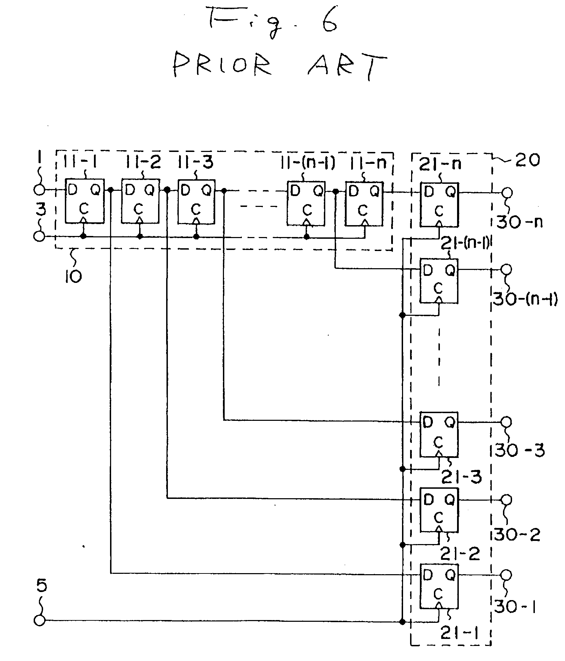

Fig. 6 is a circuit diagram showing a serial-to-parallel converter in accordance with the prior art.

A shift resistor 10 comprises D-type flip-flops (FF)11-1∼11-n (n≥2, n: integral number). A data input terminal D of FF11-1 connects to a serial data input terminal1 which serially receiving a data comprised a plurality of bits at a bit unit. A data input terminal D of FF 11-2 connects to an output terminal Q of FF 11-1. Connections for FF 11-3∼11-n continue in this manner. An output terminal Q of FF 11-n is connected to a parallel converter 20. A serial clock input terminal 3 is respectively connected to clock terminals of FF 11-1∼11-n.

FF 11-1∼11-n respectively stores the plurality of bits at a bit unit in response to the common serial clock. Therefore, when n bits data are received at the serial data input terminal 1, the shift resistor 10 can store the data at n clock cycle.

A parallel converter 20 comprises D-type flip-flops (FF)21-1∼21-n (n≥2, n: integral number). A data input terminal D of FF 21-1 is connected to an output terminal Q of FF 11-1. An output terminal Q of FF 21-1 is connected to a parallel data output terminal 30-1. Connections for FF 21-2∼21-n continue in this manner. A parallel clock input terminal5 receives a parallel clock signal and is respectively connected to clock terminals of FF 21-1∼21-n.

In the parallel converter 20, in response to the parallel clock signal, FF 21-1∼21-n respectively can store and output, at a bit unit, the plurality of bits received at the data input terminal D. Therefore, when n bits data are stored at the shift resistor 10, the parallel converter 20 can parallel output n bits data to the parallel data output terminals 30-1∼30-n (n≥2, n: integral number).

The serial-to-parallel converter of Fig. 6 requires a relatively large device area due to the high number of D-type flip flop circuits that are needed. That is, in the case of n parallel data outputs, 2n D-type flip flops are required. Also, since all of the flip flops 11-1∼11-n and 21-1∼21-n are clocked simultaneously, operational noise can result.

### SUMMARY OF THE INVENTION

An object of the present invention is to provide a serial-to-parallel converter that can decrease an occurrence of an operation noise and improve reliability of a circuit operation.

According to one aspect of the present invention, for achieving the above object, there is provided a serial-to-parallel converter comprising a data receiving circuit which stores and outputs each bit of received serial data in response to a clock transition of a first clock signal from a first potential level to a second potential level; and a parallel converter having a plurality of store circuits, wherein each of said store circuits stores and outputs a bit of data output from said data receiving circuit in response to a transition of a respective one of a plurality of second clock signals, the second clock signals having successive clock transitions from the first potential level to the second potential level so as to clock the plurality of store circuits in succession.

According to another aspect of the present invention, for achieving the above object, there is provided a serial-to-parallel converter comprising a first delay circuit, having an input terminal and an output terminal and a clock terminal, which receives serial data at said input terminal and which outputs at said output terminal a logic level of said serial data during each clock transition of a first clock signal applied to said clock terminal; and *n* second delay circuits where *n* is an integer greater than 1, each having an input terminal and an output terminal and a clock terminal, said input terminals of said *n* second delay circuits coupled to said output terminal of said first delay circuit, and said second clock terminals of said *n* second delay circuits receiving *n* second clock signals, respectively; wherein each of said *n* second delay circuits outputs at a respective output terminal thereof a logic level of said output terminal of said first delay circuit during each clock transition of a respective one of said *n* clock signals applied to a clock terminal thereof, and wherein said *n* clock signals are out of phase with one another whereby said *n* second delay circuits are clocked in succession.

According to another aspect of the present invention, for achieving the above object, there is provided a serial-to-parallel converter comprising a first delay circuit, having an input terminal and an output terminal and a clock terminal, which receives serial data at said input terminal and which outputs at said output terminal a logic level of said serial data during each clock transition of a first clock signal applied to said clock terminal of said first delay circuit; second and third delay circuits, each having an input terminal, an output terminal and a clock terminal, said input terminals of said second and third delay circuits coupled to said output terminal of said first delay circuit, and said clock terminals of said second and third delay circuits receiving second and third clock signals respectively, wherein each of said second and third delay circuits output at a respective output terminal thereof a logic level of said output terminal of said first delay circuit during each clock transition of a respective one of said second and third clock signals applied to a clock terminal thereof, and wherein said second and third clock signals are out of phase with one another whereby said second and third delay circuits are clocked in succession; a first group comprised in n fourth delay circuits where n is an integer greater than 1, each having an input terminal, an output terminal and a clock terminal, said each input terminal of n fourth delay circuits of said first group coupled to said output terminal of said second delay circuit, and said each clock terminal of n fourth delay circuits of said first group receiving a first n of 2n fourth clock signals respectively, wherein each of n fourth delay circuits of said first group outputs at a respective output terminal thereof a logic level of said output terminal of said second delay circuit during each clock transition of a respective one of said first n of 2n fourth clock signals applied to a clock terminal thereof; and a second group comprised in n fourth delay circuits where n is an integer greater than 1, each having an input terminal, an output terminal and a clock terminal, said each input terminal of n fourth delay circuits of said second group coupled to said output terminal of said third delay circuit, and said each clock terminals of n fourth delay circuits of said second group receiving a second n of 2n fourth clock signals, respectively, wherein each of said second group of n fourth delay circuits outputs at a respective output terminal thereof a logic level of said output terminal of said third delay circuit during each clock transition of a respective one of said second n of 2n fourth clock signals applied to a clock terminal thereof; wherein said 2n fourth clock signals are out of phase with one another whereby said first and second groups of 2n fourth delay circuits are clocked in succession.

### BRIEF DESCRIPTION OF THE DRAWINGS

While the specification concludes with claims particularly pointing out and distinctly claiming the subject matter that is regarded as the invention, the invention, along with the objects, features, and advantages thereof, will be better understood from the following description taken in connection with the accompanying drawings, in which:
Fig. 1 is a circuit diagram showing a serial-to-parallel converter according to a first embodiment of the present invention.
Fig. 2 is a timing chart for describing the operation of the serial-to-parallel converter shown in Fig. 1.
Fig. 3 is a circuit diagram showing a serial-to-parallel converter according to a second embodiment of the present invention.
Fig. 4 is a circuit diagram showing a serial-to-parallel converter according to a third embodiment of the present invention.
Fig. 5 is a timing chart for describing the operation of the serial-to-parallel converter shown in Fig. 4.
Fig. 6 is a circuit diagram showing a serial-to-parallel converter in accordance with the prior art.

### DETAILED DESCRIPTION OF THE PREFERRED EMBODIMENTS

A first embodiment of a serial-to-parallel converter according to the present invention will hereinafter be described in detail with reference to the accompanying drawings.

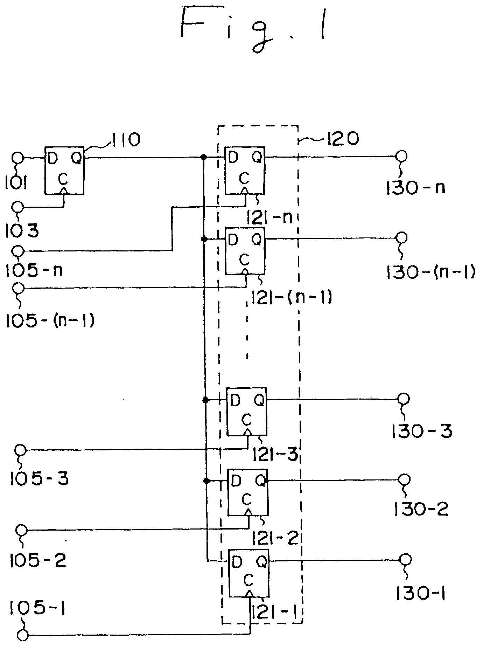

Fig. 1 is a circuit diagram showing a serial-to-parallel converter according to a first embodiment of the present invention.

As shown in Fig. 1, a serial-to-parallel converter comprises D-type flip-flops (FF)110 which is a data receiving circuit serially receiving each bit of data consisting of a plurality of bits, and a parallel converter 120 receiving output from the data receiving circuit. A data input terminal D of FF 110 is connected to a serial data input terminal 101 successively receiving each bit of data consisting of a plurality of bits. A clock terminal C of FF 110 is connected to a serial clock input terminal 103 receiving a serial clock signal which is a first clock signal. The FF 110 has a data output terminal Q.

The FF 110 stores and outputs a bit received at the serial data input terminal D in response to the rising edge of the serial clock signal.

The parallel converter 120 comprises a plurality of D-type flip-flops (FF) 121-1∼121-n (n≥2, n: integral number) which are store circuits.

In FF 121-1∼121-n, each of data input terminals D is connected to the data output terminal Q of FF 110.

Each of clock terminals C of FF 121-1∼121-n is connected to each of a plurality of parallel clock input terminals 105-1∼105-n (n≥2, n: integral number).

Each of the parallel clock input terminals is respectively received one of a plurality of parallel clock signals which are second clock signals.

Each of the FF 121-1∼121-n have each of data output terminals Q which are respectively connected to output terminals 130-1∼130-n.

The parallel converter 120 constructed as described above stores and outputs predetermined bits outputted from the FF 110 in response to each of rising edges of the plurality of the parallel clock signals.

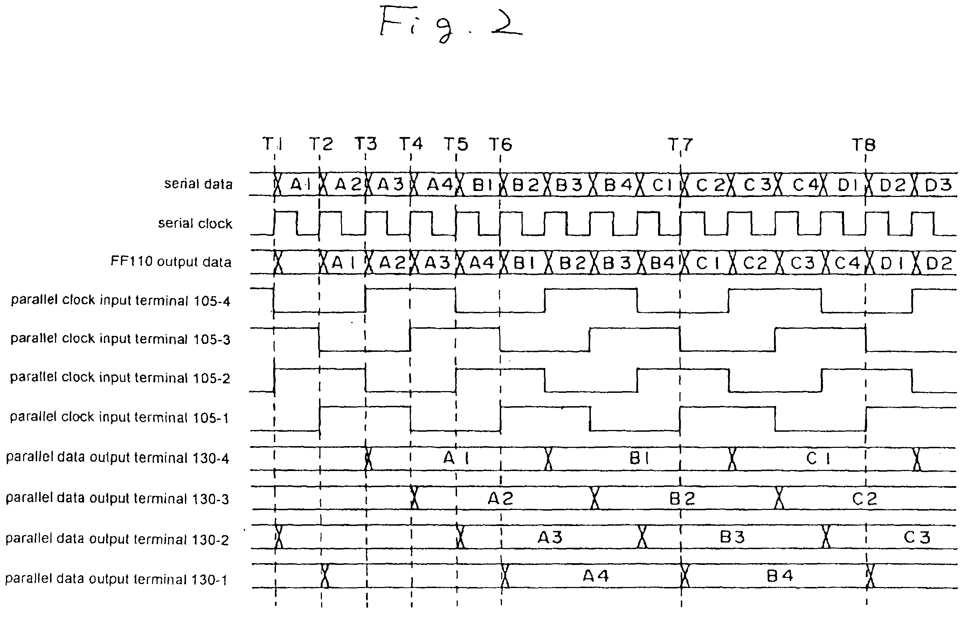

The operation of the serial-to-parallel converter of the first embodiment constructed as described above will now be described with reference to a circuit diagram shown in Fig. 1 and a timing chart shown in Fig. 2.

At an initial stage, each of FF 110 and FF 121-1∼121-4 store 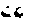 0 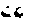 as an invalid data. Both of the serial clock signal and the parallel clock signals received at the parallel clock input terminals 105-1, 105-2 are in a low potential level. The parallel clock signal received at the parallel clock input terminals 105-3, 105-4 are in a high potential level.

At a timing T1, the serial data input terminal 101 receives a bit A1 in data consisted of four bits A1∼A4, in response to a rising edge of the serial clock signal. The parallel clock input terminal 105-2 also rises before the timing T1. But since the output of FF 110 stores and outputs 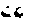 0" as invalid data in the initial stage, 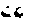 0" stores and outputs to the FF 121-2.

At a timing T2, FF110 stores and outputs the bit A1 received at the serial data input terminal 101, in response to a rising edge of the serial clock signal. Here, the serial data input terminal 101 receives a next bit A2 at behind the timing of the rising edge of the serial clock signal. If the serial data input terminal 101 receives the next bit A2 at the timing of the rising edge of the serial clock signal, the next bit A2 is taken in FF 110. Since the serial data input terminal 101 receives the next bit A2 at behind the timing of the rising edge of the serial clock signal, this invention can avoid the above problem. Further, a parallel clock signal inputted to a parallel clock input terminal 105-1 rises. Here, an output of the bit A1 delays in FF 110 because of an operation delay of the FF 110. That is reason why FF121-1 stores data 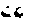 0 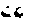 which FF110 outputted before A1.

At a timing T3, in response to a rising edge of the serial clock signal, FF 110 stores and outputs the bit A2 received at the serial data input terminal 101. Here, the serial data input terminal 101 receives a next bit A3 at behind the timing of the rising edge of the serial clock signal. And, the parallel clock signal inputted to the parallel clock input terminal 105-4 rises.

Here, an output of the bit A3 delays in FF 110 because of an operation delay of the FF 110. That is reason why FF 121-4 stores A1 which FF 110 outputted before A2.

At timings T4∼T6, in response to each rising edges of each parallel clock signals inputted to each parallel clock input terminals 105-3∼105-1, FF 121-3∼121-1 store and output bits A2∼A4 outputted from FF 110, respectively. Accordingly, the parallel converter 120 parallel outputs to each parallel data output terminals 130-4∼130-1 data consisted of four bits of bits A1∼A4 serially inputted, respectively. Here, the FF 110 stores and outputs a bit B1 received at the serial data input terminal 101.

At timings T7 and T8, the parallel converter 120 parallel outputs each of data consisted of four bits of bits B1∼B4 and data consisted of four bits of bits C1∼C4 in response to a rising edge of each of a plurality of parallel clock signals. Further, the bit outputted from the parallel data output terminal 130-1 is the bit of four bits finally inputted to the serial data input terminal 101(the bit A4 as shown in Fig. 2), and the bit outputted from the parallel data output terminal 130-4 is the bit of four bits first inputted to the serial data input terminal 101(the bit A1 as shown in Fig. 2).

In the serial-to-parallel converter of the first embodiment, since the timings of each rising edges of a plurality of the parallel clock signals respectively shifts a phase at every cycle of the serial clock signal, all of FF consisted of the serial-to-parallel converter simultaneously don't operate.

Accordingly, the first embodiment can decrease an occurrence of an operation noise when a serial-to-parallel converter operates. Further, the first embodiment can shrink a size of a serial-to-parallel converter circuit.

A second embodiment of a serial-to-parallel converter according to the present invention will hereinafter be described in detail with reference to the accompanying drawings.

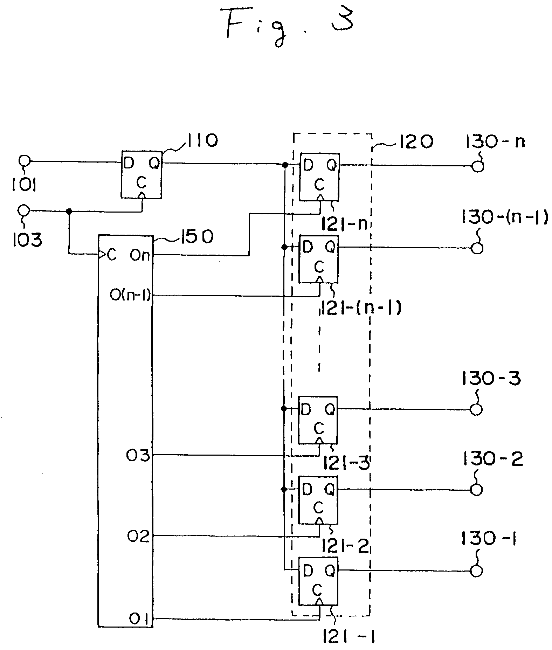

Fig. 3 is a circuit diagram showing a serial-to-parallel converter according to a second embodiment of the present invention.

As shown in Fig. 3, a feature of the second embodiment is to have a clock dividing circuit 150. The clock dividing circuit 150 receives a serial clock signal and which divides the serial clock signal. Then, the clock dividing circuit 150 outputs a plurality of a parallel clock signals rising in a state of shifting a phase at every cycle of the serial clock signal.

Then, the clock dividing circuit 150 respectively outputs a plurality of the parallel clock signals to each FF 121-1∼121-n in a parallel converter 120.

Accordingly, since the second embodiment can generate the parallel clock signals synchronized with the serial clock signal in the serial-to-parallel converter, the second embodiment can decrease the number of input signals and input signal terminals from the outside in order to receive a plurality of the parallel clock signals. Further, since the parallel clock signals easily synchronize with the serial clock signal, the second embodiment can improve reliability of a circuit operation.

A third embodiment of a serial-to-parallel converter according to the present invention will hereinafter be described in detail with reference to the accompanying drawings.

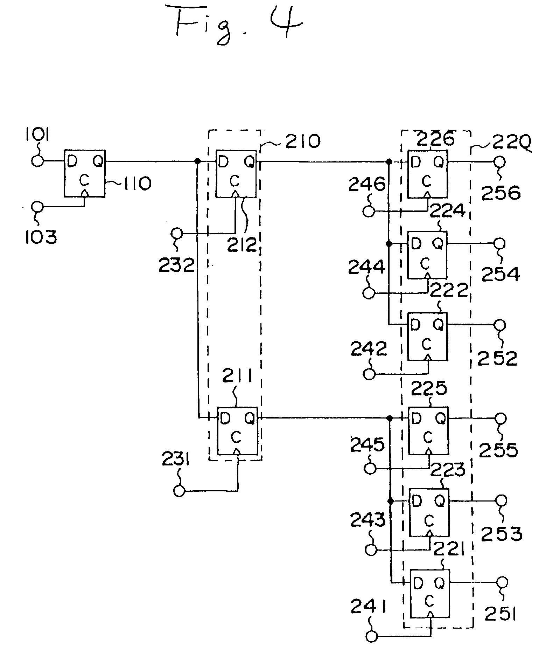

Fig. 4 is a circuit diagram showing a serial-to-parallel converter according to a third embodiment of the present invention.

As shown in Fig. 4, a feature of the third embodiment is to have first data receiving circuit comprising a FF110 and a second data receiving circuit acting as a data transfer circuit 210. The data transfer circuit 210 comprises D-type flip-flops 211, 212 (FF211, FF212). Each data input terminals D of FF 211 and FF 212 connects with an output terminal Q of FF 110. A clock terminal C of the FF 211 connects with a second parallel clock signal input terminal 231 being received one of a plurality of second parallel clock signals. In the same way as that one. A clock terminal of the FF 212 connects with a second parallel clock signal input terminal 232 being received other one of the plurality of second parallel clock signals. And, the FF 211 and the FF 212 respectively have an output terminal Q. For example, the plurality of second parallel clock signals are shown two signals. The two signals have a complimentary potential levels each other. And, one clock cycle of each second parallel clock signals equals to two clock cycles of a serial clock signal.

The data transfer circuit 210 constructed as described above stores and outputs a bit of a serial data being outputted from the FF 110 to the FF 211 or the FF 212 in response to a rising edge of the second parallel clock signal. Here, since two second parallel clock signals have a complimentary potential levels each other, the data transfer circuit 210 stores a bit of a serial data being outputted from the FF 110, at a bit, at a timing shifted at every ½ cycle each other.

A parallel converter 220 comprises a plurality of D-type flip-flops (FF) 221∼226 which is grouped into blocks corresponding with the number of outputs of the data transfer circuit 210. Here, since the data transfer circuit 210 has two outputs, it is grouped into a first FF group being received one of two outputs and a second FF group being received other one of two outputs. The data transfer circuit 210 comprises a first block comprising FF 221, 223, 225 being received an output of the FF 211 to each data input terminal D of FF 221, 223, 225 and a second block comprising FF 222, 224, 226 being received an output of the FF 212 to each data input terminal D of FF 222, 224, 226. Each clock terminals C of the FF 221, 223, 225 respectively connects with first parallel clock input terminals 241, 243, 245 being received one of a plurality of the first parallel clock signals. In the same way as that one. Each clock terminals C of the FF 242, 244, 246 respectively connects with first parallel clock input terminals 222, 224, 226 being received one of a plurality of the first parallel clock signals. And, the FF 221∼226 respectively have an output terminal Q. Here, the FF 221∼226 respectively are inputted to the first parallel clock signal rising in on state of shifting a phase at every cycle of the serial clock signal. Here, A cycle of each first parallel clock signals equals to six cycles of the serial clock signal.

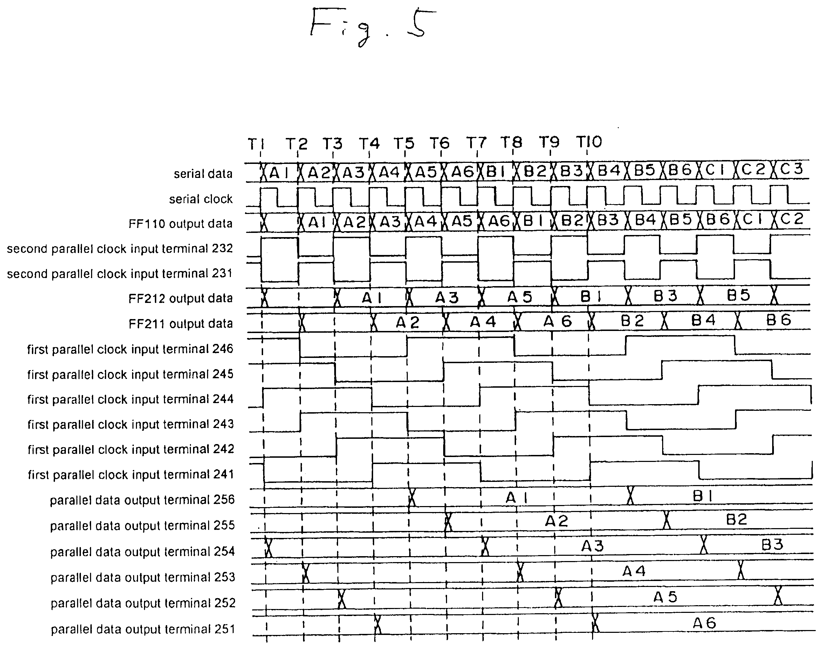

The operation of the serial-to-parallel converter of the third embodiment constructed as described above will now be described with reference to a circuit diagram shown in Fig. 4 and a timing chart shown in Fig. 5.

At an initial stage, the third embodiment suppose that the FF 110, 211, 212, 221∼226 are stored 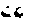 0" as a invalid data and that both of a second parallel clock input terminal 232 being received the serial clock signal and the second parallel clock signal and the first parallel clock input terminal 242∼244 being received the first parallel clock signal are on a low level, and that both of a second parallel clock input terminal 231 being received the second parallel clock signal and the second parallel clock signal and the first parallel clock input terminal 241, 245, 246 being received the first parallel clock signal are on a high level.

At a timing T1, the serial data input terminal 101 receives a bit A1 in data being constructed from a six bits of bit A1∼A6 in response to a rising of the serial clock signal. Here, both of the second parallel clock signal being inputted to second parallel clock input terminal 232 and the first parallel clock signal being inputted to the first parallel clock input terminal 244 also rise. However, since outputs of FF 110, 212 are 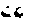 0" as an invalid data, FF 212, 224 store and output 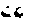 0" as an invalid data.

At a timing T2, FF 110 stores and outputs the bit A1 received at the serial data input terminal 101 in response to a rising of the serial clock signal. Here, the serial data input terminal 101 receives a next bit A2 at behind the timing of the rising edge of the serial clock signal. If the serial data input terminal 101 receives the next bit A2 at the timing of the rising edge of the serial clock signal, the next bit A2 is stored in FF 110. Since the serial data input terminal 101 receives the next bit A2 at behind the timing of the rising edge of the serial clock signal, this invention can avoid the above problem. Further, both of the second parallel clock signal inputted to the second parallel clock input terminal 231 and the first parallel clock signal inputted to the first parallel clock input terminal 243 also rise. However, since an output of the bit A1 delays in FF 110 because of an operation delay of the FF 110, FF 211 stores , in response to a rising edge of the second parallel clock signal, data 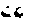 0 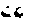 which FF 110 outputted before A1 is stored. And, since an output of FF 211 outputs data 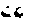 0 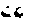 , FF223 stores and outputs data 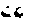 0 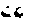 .

At a timing T3, FF 110 stores and outputs the bit A2 received at the serial data input terminal 101 in response to a rising of the serial clock signal. Here, the serial data input terminal 101 receives a next bit A3 at behind the timing of the rising edge of the serial clock signal. If the serial data input terminal 101 receives the next bit A3 at the timing of the rising edge of the serial clock signal, the next bit A3 is taken in FF 110. Since the serial data input terminal 101 receives the next bit A3 at behind the timing of the rising edge of the serial clock signal, this invention can avoid the above problem. Further, the second parallel clock signal inputted to the second parallel clock input terminal 232 also rises. However, since an output of the bit A2 delays in FF 110 because of an operation delay of the FF 110, FF 212 stores and outputs, in response to a rising edge of the second parallel clock signal, the bit A1 which FF 110 outputted before A2 is stored. Further, the first parallel clock signal inputted to the first parallel clock input terminal 242 also rises. However, since an output of the bit A1 delays in FF 212 because of an operation delay of the FF 212, FF 222 stores and outputs, in response to a rising edge of the first parallel clock signal, data 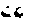 0" which FF212 outputted before A1 is stored.

At a timing T4, FF 110 stores and outputs the bit A3 received at the serial data input terminal 101 in response to a rising of the serial clock signal. Here, the serial data input terminal 101 receives a next bit A4 at behind the timing of the rising edge of the serial clock signal. Further, the second parallel clock signal inputted to the second parallel clock input terminal 231 also rises. However, since an output of the bit A3 delays in FF 110 because of an operation delay of the FF 110, FF 211 stores and outputs, in response to a rising edge of the second parallel clock signal, the bit A2 which FF 110 outputted before the bit A3 is stored. Here, the first parallel clock signal inputted to the first parallel clock input terminal 241 also rises. However, since an output of the bit A2 delays in FF 211 because of an operation delay of the FF 211, FF 221 stores and outputs, in response to a rising edge of the first parallel clock signal, data 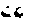 0" which FF 211 outputted before the bit A2 is outputted.

At a timing T5, FF 110 stores and outputs the bit A4 received at the serial data input terminal 101 in response to a rising of the serial clock signal. Here, the serial data input terminal 101 receives a next bit A5 at behind the timing of the rising edge of the serial clock signal. Further, the second parallel clock signal inputted to the second parallel clock input terminal 232 also rises. However, since an output of the bit A4 delays in FF 110 because of an operation delay of the FF 110, FF 212 stores and outputs, in response to a rising edge of the second parallel clock signal, the bit A3 which FF 110 outputted before the bit A4 is stored. Here, the first parallel clock signal inputted to the first parallel clock input terminal 246 also rises. However, since an output of the bit A3 delays in FF 212 because of an operation delay of the FF 212, FF 226 stores and outputs, in response to a rising edge of the first parallel clock signal, the bit A1 which FF 211 outputted before the bit A3 is stored.

At a timing T6, FF 110 stores and outputs the bit A5 received at the serial data input terminal 101 in response to a rising of the serial clock signal. Here, the serial data input terminal 101 receives a next bit A6 at behind the timing of the rising edge of the serial clock signal. Further, the second parallel clock signal inputted to the second parallel clock input terminal 231 also rises. However, since an output of the bit A5 delays in FF 110 because of an operation delay of the FF 110, FF 211 stores and outputs, in response to a rising edge of the second parallel clock signal, the bit A4 which FF 110 outputted before the bit A5 is stored. Here, the first parallel clock signal inputted to the first parallel clock input terminal 245 also rises. However, since an output of the bit A4 delays in FF 211 because of an operation delay of the FF 211, FF 225 stores and outputs, in response to a rising edge of the first parallel clock signal, the bit A2 which FF 211 outputted before the bit A4 is stored.

At a timing T7, FF 224 stores and outputs the bit A3 being outputted from FF 212 in response to a rising edge of the first parallel clock signal being inputted to the first parallel clock input terminal 244.

At a timing T8, FF 223 stores and outputs the bit A4 being outputted from FF 211 in response to a rising edge of the first parallel clock signal being inputted to the first parallel clock input terminal 243.

At a timing T9, FF 222 stores and outputs the bit A5 being outputted from FF 212 in response to a rising edge of the first parallel clock signal being inputted to the first parallel clock input terminal 242.

At a timing T10, FF 221 stores and outputs the bit A6 being outputted from FF 211 in response to a rising edge of the first parallel clock signal being inputted to the first parallel clock input terminal 241.

The parallel converter 220 outputs data being constructed six bits of bits A1∼A6 serially inputted , to the parallel output terminals 251∼256. Here, FF 110 stores and outputs the bit B1 at the serial data input terminal 101. And, the bit of data being outputted from the parallel output terminal 251 is finally bit inputted to the serial data input terminal 101 in the six bits. ( A6 as shown in Fig. 5) And, the bit of data being outputted from the parallel output terminal 256 is the first bit inputted to the serial data input terminal 101 in the six bits. ( A1 as shown in Fig. 5)

In the third embodiment constructed as described above, since the serial-to-parallel converter has the data transfer circuit 210, it alternately stores outputs from FF 110 using complimentary two parallel clock signals and then respectively output stored bit. And, the third embodiment groups the FF221∼226 into some blocks corresponding with the number of outputs of the data transfer circuit 210, and respectively stores and outputs the bits in response to the first parallel clock signal one by one. Further, since the timing of rising of a plurality of the first parallel clock signal shifts a phase at every cycle of the serial clock signal, all of FF being constructed the serial-to-parallel converter doesn't simultaneously operate.

Accordingly, the third embodiment can decrease an occurrence of an operation noise.

Further, the third embodiment can shrink a size of a serial-to-parallel converter circuit.

Further, since the third embodiment can maintains an output from FF 110 for longer period than a cycle of the serial clock signal in order to provide the data transfer circuit 210, it can easily increase an operation margin and certainly transfers the bits of data to the parallel converter 220. Accordingly, the third embodiment can improve reliability of an operation of the serial-to-parallel converter.

While the present invention has been described with reference to the illustrative embodiments, this description is not intended to be construed in a limiting sense. Various modifications of the illustrative embodiments, as well as other embodiments of the invention, will be apparent to those skilled in the art on reference to this description. It is therefore contemplated that the appended claims will cover any such modifications or embodiments as fall within the true scope of the invention.

## Claims

1. A serial-to-parallel converter comprising:
a data receiving circuit which stores and outputs each bit of received serial data in response to a clock transition of a first clock signal from a first potential level to a second potential level; and
a parallel converter having a plurality of store circuits, wherein each of said store circuits stores arid outputs a bit of data output from said data receiving circuit in response to a transition of a respective one of a plurality of second clock signals, the second clock signals having successive clock transitions from the first potential level to the second potential level so as to clock the plurality of store circuits in succession.

2. A serial-to-parallel converter as claimed in Claim 1, further comprising a divider circuit which divides a frequency of the first clock signal to generate the second clock signals.

3. A serial-to-parallel converter as claimed in Claim 1, wherein said data receiving circuit comprises:
a first receiving circuit which stores and outputs each bit of the received serial data in response to the clock transition of the first clock signal from the first potential level to the second potential level, and
a second receiving circuit, having a plurality of outputs, which stores and outputs a bit of data output from said first receiving circuit in response to a clock transition of each of a plurality of third clock signals, the third clock signals having successive clock transitions from the first potential level to the second potential level so as to successively output bits of data from said plurality of outputs, respectively, wherein each of said store circuits of said converter receive one of said plurality of outputs of said second receiving circuit.

4. A serial-to-parallel converter comprising:
a first delay circuit, having an input terminal and an output terminal and a clock terminal, which receives serial data at said input terminal and which outputs at said output terminal a logic level of said serial data during each clock transition of a first clock signal applied to said clock terminal; and
*n* second delay circuits where *n* is an integer greater than 1, each having an input terminal and an output terminal and a clock terminal, said input terminals of said *n* second delay circuits coupled to said output terminal of said first delay circuit, and said second clock terminals of said *n* second delay circuits receiving *n* second clock signals, respectively;
wherein each of said *n* second delay circuits outputs at a respective output terminal thereof a logic level of said output terminal of said first delay circuit during each clock transition of a respective one of said *n* clock signals applied to a clock terminal thereof, and therein said *n* clock signals are out of phase with one another whereby said *n* second delay circuits are clocked in succession.

5. A serial-to-parallel converter as claimed in Claim 4, further comprising a frequency divider circuit which receives the first clock signal and outputs the *n* second clock signals.

6. A serial-to-parallel converter as claimed in Claim 5, wherein a frequency of the first clock signal is *n* times a frequency of each of the *n* second clock signals.

7. A serial-to-parallel converter as claimed in Claim 4, wherein said first delay circuit is a flip flop which temporary stores a data.

8. A serial-to-parallel converter as claimed in Claim 4, wherein each of said *n* second delay circuits is a flip flop which temporary stores a data.

9. A serial-to-parallel converter comprising:
a first delay circuit, having an input terminal and an output terminal and a clock terminal, which receives serial data at said input terminal and which outputs at said output terminal a logic level of said serial data during each clock transition of a first clock signal applied to said clock terminal of said first delay circuit;
second and third delay circuits, each having an input terminal, an output terminal and a clock terminal, said input terminals of said second and third delay circuits coupled to said output terminal of said first delay circuit, and said clock terminals of said second and third delay circuits receiving second and third clock signals respectively, wherein each of said second and third delay circuits output at a respective output terminal thereof a logic level of said output terminal of said first delay circuit during each clock transition of a respective one of said second and third clock signals applied to a clock terminal thereof, and wherein said second and third clock signals are out of phase with one another whereby said second and third delay circuits are clocked in succession;
a first group comprised in n fourth delay circuits where n is an integer greater than 1, each having an input terminal, an output terminal and a clock terminal, said each input terminal of n fourth delay circuits of said first group coupled to said output terminal of said second delay circuit, and said each clock terminal of n fourth delay circuits of said first group receiving a first n of 2n fourth clock signals respectively, wherein each of n fourth delay circuits of said first group outputs at a respective output terminal thereof a logic level of said output terminal of said second delay circuit during each clock transition of a respective one of said first n of 2n fourth clock signals applied to a clock terminal thereof; and
a second group comprised in n fourth delay circuits where n is an integer greater than 1, each having an input terminal, an output terminal and a clock terminal, said each input terminal of n fourth delay circuits of said second group coupled to said output terminal of said third delay circuit, and said each clock terminals of n fourth delay circuits of said second group receiving a second n of 2n fourth clock signals, respectively, wherein each of said second group of n fourth delay circuits outputs at a respective output terminal thereof a logic level of said output terminal of said third delay circuit during each clock transition of a respective one of said second n of 2n fourth clock signals applied to a clock terminal thereof;
wherein said 2n fourth clock signals are out of phase with one another whereby said first and second groups of 2n fourth delay circuits are clocked in succession.

10. A serial-to-parallel converter as claimed in Claim 9, further comprising a frequency divider circuit which receives the first clock signal and outputs the 2n fourth clock signals.

11. A serial-to-parallel converter as claimed in Claim 10, wherein a frequency of the first clock signal is 2n times a frequency of each of the 2n fourth clock signals.

12. A serial-to-parallel converter as claimed in Claim 9, wherein said first delay circuit is a flip flop which temporary stores a data.

13. A serial-to-parallel converter as claimed in Claim 9, wherein each of said 2n fourth delay circuits is a flip flop which temporary stores a data.

14. A serial-to-parallel converter as claimed in Claim 12, wherein each of said 2n fourth delay circuits is a flip flop.

15. A serial-to-parallel converter as claimed in Claim 9, wherein said first, second and third delay circuit and each of said 2n fourth delay circuits are a flip flop which temporary stores a data.
